# EUROPEAN PATENT APPLICATION

(11) **EP 3 675 467 A1**
(43) Date of publication of application: **01.07.2020**
(21) Application number: 18847877.0
(22) Date of filing: 17.08.2018
(51) Int. Cl.: H04M 1/02, H05K 5/00

(54) **3D GLASS-METAL COMBINATION, METHOD FOR MANUFACTURING SAME, AND ELECTRONIC PRODUCT**

(30) Priority: 25.08.2017 CN 201710740918
(71) Applicant: BYD Company Limited, Shenzhen, Guangdong 518118 (CN)
(72) Inventor: REN, Peng, Shenzhen Guangdong 518118 (CN); MA, Lan, Shenzhen Guangdong 518118 (CN); CHEN, Liang, Shenzhen Guangdong 518118 (CN); WANG, Haixia, Shenzhen Guangdong 518118 (CN)
(74) Representative: Gulde & Partner
(86) International application number: PCT/CN2018/101133
(87) International publication number: WO 2019/037670

(57) **Abstract**

The present invention discloses a 3D glass-metal composite body, a preparing method thereof, and an electronic product. The 3D glass-metal composite body comprises a 3D glass cover plate (10), a plastic frame body (20), and a metal frame (30). The plastic frame body (20) is formed between an edge surface of the 3D glass cover plate (10) and an upper surface of the metal frame (30). Outer peripheries of the 3D glass cover plate (10), the plastic frame body (20), and the metal frame (30) are in smooth transition along curvature of the 3D glass cover plate (10) without steps.

## Description

### CROSS-REFERENCE TO RELATED APPLICATIONS

The present application is set forth based on and claims priority to Chinese Patent Application No. 201710740918.3, filed on August 25, 2017, which is incorporated in the present application by reference in its entirety.

### FIELD

The present disclosure relates to the technical field of electronic products, and in particular, to a 3D glass-metal composite body, a preparing method thereof, and an electronic product.

### BACKGROUND

In the prior art, a bonding manner of a glass front screen and a metal frame usually adopts direct fitting and assembling by using glue, and the glass and the metal frame are coated with the glue to be assembled. The bonding manner of the glass and the metal frame determines the size of the binding force between a metal base material and the glass. A 3D glass-metal composite body prepared by using such a method has the following major disadvantages: (1) the bonding force between the glass and the metal base material is relatively small, the bonding is not tight, gaps exist, the waterproofness is not achieved, and the composite body is easy to fall off. (2) The fitting does not achieve bonding without steps, and the glass is caused to protrude, thereby not only increasing a thickness of the 3D glass-metal composite body, but also increasing the risk of screen breakage. (3) The preparing processes are more, the production cost is increased, and meanwhile, the defect rate is increased.

### SUMMARY

An objective of the present disclosure is to provide a 3D glass-metal composite body, a preparing method thereof and an electronic product in order to overcome the above shortcomings in the prior art. In the 3D glass-metal composite body, a bonding force between a glass and a metal base material is high, the risk of screen breakage is low, and the waterproofness is strong.

In order to achieve the above objective, a first aspect of the present disclosure provides a 3D glass-metal composite body. The 3D glass-metal composite body includes a 3D glass cover plate, a plastic frame body, and a metal frame. An upper surface of the metal frame and an edge surface of the 3D glass cover plate are oppositely disposed. At least a part of the plastic frame body is formed between the edge surface of the 3D glass cover plate and the upper surface of the metal frame, and outer peripheries of the 3D glass cover plate, the plastic frame body and the metal frame are in smooth transition along curvature of the 3D glass cover plate without steps.

A second aspect of the present disclosure provides a method for preparing a 3D glass-metal composite body. The method includes the following steps: (1) providing a 3D glass cover plate, coating an activating agent on an edge surface of the 3D glass cover plate, and drying; (2) providing a metal frame prefabricated body, where a reserved portion extending outward along an outer periphery of the metal frame is reserved for the metal frame prefabricated body relative to a final structure of the metal frame; (3) placing the 3D glass cover plate obtained in step (1) and the metal frame prefabricated body in an injection mold, where an upper surface of the metal frame prefabricated body (30') and the edge surface of the 3D glass cover plate (10) are oppositely disposed, an injection molding material is filled between the edge surface of the 3D glass cover plate and the upper surface of the metal frame prefabricated body, at least a part of the injection molding material is formed between the edge surface of the 3D glass cover plate (10) and the upper surface of the metal frame prefabricated body (30'), and a 3D glass-metal composite prefabricated body is obtained by injection molding; and (4) performing cutting treatment on the 3D glass-metal composite prefabricated body, and removing the reserved portion in the metal frame prefabricated body to obtain the 3D glass-metal composite body.

A third aspect of the present disclosure provides a 3D glass-metal composite body prepared by using the above method.

A fourth aspect of the present disclosure provides an electronic product, including the 3D glass-metal composite body according to the present disclosure.

In the 3D glass-metal composite body of the present disclosure, a bonding force between the 3D glass cover plate and the metal frame can be as high as above (a speed is 10 mm/min), and the 3D glass cover plate and the metal frame are bonded by using the plastic frame body (through a manner of injection molding, particularly, the injection molding at room temperature, and plastic is used as an intermediate to bond a metal base material and the 3D glass cover plate, thereby greatly improving the bonding force between the two). The bonding force is good, the risk of screen breakage is low, the waterproofness is strong, and thinness and beauty are achieved. The 3D glass cover plate can be assembled as a cover plate with strong practicability, and the preparing method reduces screen mounting processes, reduces the production cost, and improves the product yield.

In the method of the present disclosure, by coating the activating agent on the edge of the 3D glass cover plate, a cross-linking reaction occurs between an activating component of the activating agent and the plastic for injection molding, thereby significantly increasing the bonding force between the plastic frame body and the glass cover plate, and between the plastic frame body and the metal frame, and reducing the risk of screen breakage.

Other features and advantages of the present disclosure will be described in detail in the following detailed description.

### BRIEF DESCRIPTION OF THE DRAWINGS

The above and/or additional aspects and advantages of the present disclosure will become apparent and easy to understand from the description of the embodiments with reference to the accompanying drawings, where
FIG. 1 is a schematic structural diagram of a 3D glass-metal composite body according to the present disclosure.
FIG. 2 is a side sectional schematic structural diagram of FIG. 1.
FIG. 3 is an enlarged structural schematic diagram of position A in FIG. 2.
FIG. 4 is a schematic structural diagram of a 3D glass cover plate according to the present disclosure.
FIG. 5 is a schematic structural diagram of a metal frame prefabricated body according to the present disclosure.
FIG. 6 is a schematic structural diagram of a 3D glass-metal composite prefabricated body according to the present disclosure.

Reference signs: 10 is 3D glass cover plate, 20 is plastic frame body, 30 is metal frame, 30' is metal frame prefabricated body, 31 is outer frame, 32 is inner frame, and 33 is reserved portion.

### DETAILED DESCRIPTION

The endpoints and any values of the ranges disclosed herein are not limited to the precise range or value, and these ranges or values should be understood to include values close to these ranges or values. A numerical range between endpoint values of each range, a numerical range between an endpoint value and an individual point value of each range, and a numerical range between individual point values may be combined with each other to obtain one or more new numerical ranges, and such numerical ranges should be considered to be specifically disclosed herein.

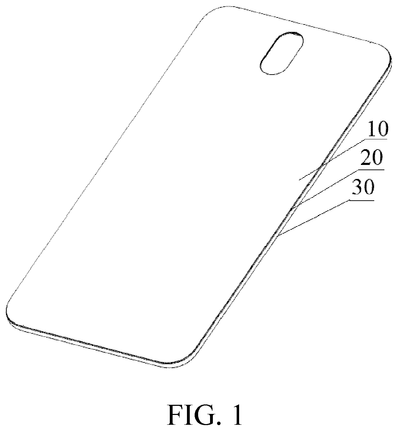

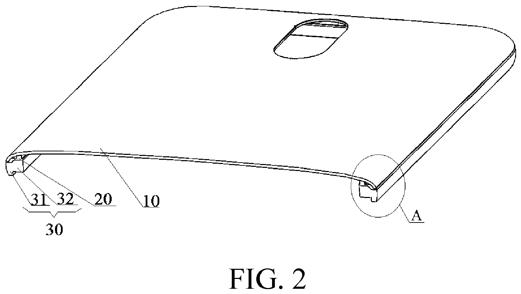

In a first aspect, the present disclosure provides a 3D glass-metal composite body, as shown in FIG. 1 and FIG. 2. The 3D glass-metal composite body includes a 3D glass cover plate 10, a plastic frame body 20, and a metal frame 30. An upper surface of the metal frame 30 and an edge surface of the 3D glass cover plate 10 are oppositely disposed. At least a part of the plastic frame body 20 is formed between the edge surface of the 3D glass cover plate 10 and the upper surface (one side surface toward the 3D glass cover plate) of the metal frame 30. Outer peripheries of the 3D glass cover plate 10, the plastic frame body 20 and the metal frame 30 are in smooth transition along curvature of the 3D glass cover plate without steps.

In the 3D glass-metal composite body of the present disclosure, those skilled in the art should understand that the edge surface of the 3D glass cover plate refers to a (outer periphery) side surface of a flat glass before a 3D glass is thermally bent, and can also be a thickness surface of the flat glass. The plastic frame body (cured and hard plastic frame body) is formed between the edge surface of the 3D glass cover plate and the upper surface of the metal frame, that is, the 3D glass cover plate, the plastic frame body, and the metal frame are disposed in sequence, and the outer peripheries of the three (sides protruding outward relative to the 3D glass) are in smooth transition along the curvature of the 3D glass cover plate (an extending direction of the glass after bending) without steps.

The smooth transition should be at least understood that outer peripheral surfaces of the plastic frame body, the metal frame and the 3D glass cover plate are located on a same curved surface, that is to say, the outer peripheral surfaces of the plastic frame body and the metal frame extend along the outer peripheral surface of the 3D glass cover plate.

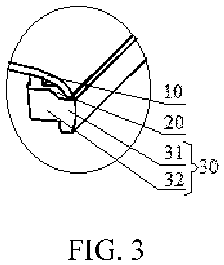

In the 3D glass-metal composite body of the present disclosure, the metal frame 30 comprises an outer frame 31 and an inner frame 32 which are integrally formed. An upper surface of the outer frame 31 and the edge surface of the 3D glass cover plate 10 are oppositely disposed. The inner frame 32 is formed inside the outer frame 31. In such a structure, the outer frame 31 mainly functions as a housing, and the inner frame 32 can be configured to match structures of internal components. A buckling structure can be formed on the inner frame 32 to fix positions of the internal components. Lower surfaces of the inner frame 32 and the outer frame 31 can also cooperate to form an adapting structure connected to other frame bodies. In order to further increase a bonding force between the 3D glass cover plate 10 and the metal frame 30, as shown in FIG. 3, according to an embodiment of the present invention, the outer periphery of the plastic frame body 20 and an outer periphery of the outer frame 31, and an inner periphery of the plastic frame body 20 and an inner periphery of the inner frame 32 are correspondingly formed between the 3D glass cover plate 10 and the metal frame 30. In this case, a bonding area between the plastic frame body 20 and the 3D glass cover plate 10 and between the plastic frame body 20 and the metal frame 30 is increased, which is further favorable to increase bonding strength between the 3D glass cover plate 10 and the metal frame 30.

In the 3D glass-metal composite body of the present disclosure, in order to further increase the bonding force between the 3D glass cover plate 10 and the metal frame 30, as shown in FIG. 3, preferably, an upper surface of the inner frame 32 is higher than the upper surface of the outer frame 31. Preferably, the upper surface of the inner frame 32 and the upper surface of the outer frame 31 are connected in an arc-shaped transition manner. In this case, a width of the upper surface of the outer frame 31 (a length perpendicular to an extending direction of a middle side of the outer frame) is greater than a width of the edge surface of the 3D glass cover plate 10, to reserve a filling space of the plastic frame body 20. In this structure, the bonding area between the plastic frame body 20 and the metal frame 30 is increased, which is further favorable to increase the bonding strength between the 3D glass cover plate 10 and the metal frame 30.

In the 3D glass-metal composite body of the present disclosure, there may be no special requirement for thicknesses of the 3D glass cover plate 10, the plastic frame body 20, and the metal frame 30, and corresponding designs may be performed according to actual needs. For example, the thickness of the glass cover plate 10 (i.e., the width of the edge surface) can be 0.3 to 2 mm. In this case, the thickness of the plastic frame body 20 located between the edge surface of the glass cover plate 10 and the outer frame 31 in the metal frame 30 is 0.5 to 1 mm. The width of the upper surface of the outer frame 31 in the metal frame 30 is greater than the width of the edge surface of the glass cover plate 10 by 0.5 to 2 mm. A width of the inner frame 32 in the metal frame 30 is 1 to 2 mm, and the upper surface of the inner frame 32 is higher than the upper surface of the outer frame 31 by 0.1 to 2.5 mm.

In the 3D glass-metal composite body of the present disclosure, the 3D glass cover plate 10 may be a single curved glass cover plate (formed by bending a group of oppositely disposed edges), or may be a double-curved glass cover plate (formed by simultaneously bending two groups of oppositely disposed edges). Preferably, the 3D glass cover plate is the double-curved glass cover plate, and a structural force of the double-curved glass cover plate with the metal frame is more uniform and stable.

In the 3D glass-metal composite body of the present disclosure, a material of the plastic frame body 20 may be a thermoplastic or a thermosetting resin. The thermoplastic resin may be selected from PC, PA, PPS, PBT, and the like, and the thermosetting resin may be selected from phenol resin, epoxy resin, diallyl phthalate, and the like. In order to significantly improve the bonding force between the 3D glass cover plate and the metal frame, and significantly reduce the risk of screen breakage, for example, in an embodiment of the present disclosure, the material of the plastic frame body is at least one of polyamide (PA), glass fiber (GF), polycarbonate (PC) and polyphenylene sulfide (PPS). For example, in another embodiment of the present disclosure, the material of the plastic frame body is a mixture of at least one of the polyamide, polycarbonate, and polyphenylene sulfide and the glass fiber. For example, in yet another embodiment of the present disclosure, the material of the plastic frame body is a mixture of the polyamide and the glass fiber.

In an embodiment of the present disclosure, a ratio of a total weight of at least one of the polyamide, polycarbonate, and polyphenylene sulfide to a weight of the glass fiber in the plastic frame body is (0.5 to 5):1. Further in another embodiment of the present disclosure, the ratio is (1 to 3):1. Those skilled in the art should understand that when the plastic frame body contains one of the polyamide, polycarbonate, and polyphenylene sulfide, the total weight of at least one of the polyamide, polycarbonate, and polyphenylene sulfide is a weight of the one substance. When the plastic frame body contains two or more of the polyamide, polycarbonate, and polyphenylene sulfide, the total weight of at least one of the polyamide, polycarbonate, and polyphenylene sulfide is a sum of weights of the two or more substances. In the present disclosure, the polyamide, glass fiber, polycarbonate, and polyphenylene sulfide are commercially available.

In the 3D glass-metal composite body of the present disclosure, a metal base material is not particularly restricted, and the metal base material may be various metal base materials commonly used in the art. In an embodiment of the present disclosure, the metal base material is a stainless steel base material or an aluminum alloy base material.

In the 3D glass-metal composite body of the present disclosure, in order to further improve the bonding force between the 3D glass cover plate 10 and the metal base material and significantly reduce the risk of screen breakage, in an embodiment of the present disclosure, an anode oxide film layer is formed on a surface of the metal frame, and micropores are further formed in an outer surface layer of the anode oxide film layer. The above metal frame can be prepared by using a method including the following processing steps: sequentially performing machining and molding, polishing, chemical polishing, sandblasting treatment, anode oxidizing treatment, micropore treatment, and film laminating treatment on the stainless steel or aluminum alloy. For specific steps, refer to the corresponding content described below in detail.

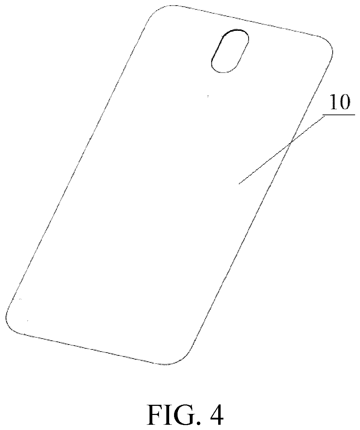

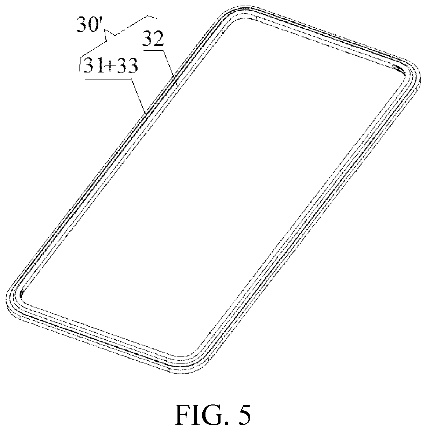

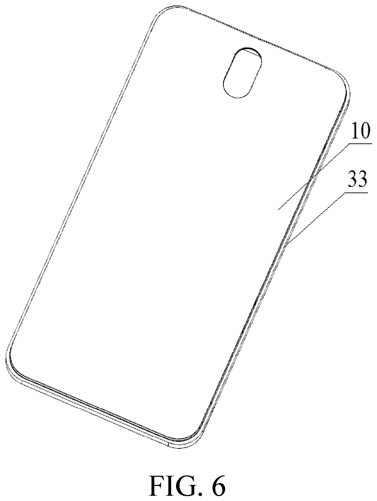

In a second aspect, the present disclosure provides a preparing method for a 3D glass-metal composite body. The method includes: (1) providing a 3D glass cover plate 10 (as shown in FIG. 4), and coating an activating agent on an edge surface of the 3D glass cover plate 10 and drying; (2) providing a metal frame prefabricated body 30' (as shown in FIG. 5), where a reserved portion 33 extending outward along an outer periphery of the metal frame 30 is reserved for the metal frame prefabricated body 30' relative to a final structure of the metal frame 30; (3) placing the 3D glass cover plate 10 obtained in step (1) and the metal frame prefabricated body 30' in an injection mold, filling an injection molding material between the edge surface of the 3D glass cover plate 10 and an upper surface of the metal frame prefabricated body 30, and obtaining a 3D glass-metal composite prefabricated body by injection molding (as shown in FIG. 6); and (4) performing cutting treatment on the 3D glass-metal composite prefabricated body, removing the reserved portion 33 in the metal frame prefabricated body 30' to obtain the 3D glass-metal composite body.

The inventors of the present disclosure found during a research on a bonding force between glass and metal that the bonding force between the glass and the metal may be improved through injection molding (filling the injection molding material). However, the 3D glass is different from the flat glass. Due to a special structure of the 3D glass and machining tolerance during the processing of the 3D glass cover plate and the metal frame, it is difficult to enable the 3D glass cover plate and the metal frame to be completely matched in size. After injection molding, obvious gaps and steps on the outer peripheries of the 3D metal cover plate, the plastic frame body and the metal frame always exist, which will affect the appearance and sealing of the product. In view of the existence of the problem, the inventors of the present disclosure have improved the method again, and proposed a solution of using a metal frame prefabricated body in the injection molding process. The reserved portion extending outward along the outer periphery of the metal frame is reserved for the metal frame prefabricated body relative to the final structure of the metal frame. In the injection molding process, the reserved portion can play a certain role of blocking the injection molding material overflowing outward, so that the injection molding material can be more tightly cured between the 3D glass base plate and the metal frame to form a stable and sealed structure. After injection molding, the 3D glass-metal composite prefabricated body is subjected to the cutting treatment (i.e., CNC processing). By removing the reserved portion in the metal frame prefabricated body (while an excess part in the plastic frame is removed), it is beneficial to improve the beauty of the prepared 3D glass-metal composite body.

In the method of the present disclosure, according to an embodiment of the present disclosure, the metal frame 30 includes an outer frame 31 and an inner frame 32 which are integrally formed. The outer frame 31 and the edge surface of the 3D glass cover plate 10 are oppositely disposed. The inner frame 32 is formed inside the outer frame 31, and the reserved portion 33 is formed on an outer periphery of the outer frame 31. According to an embodiment of the present disclosure, an upper surface of the inner frame 32 is higher than an upper surface of the outer frame 31, and the upper surface of the inner frame 32 and the upper surface of the outer frame 31 are connected in an arc-shaped transition manner. In this case, a width (a length perpendicular to an extending direction of a middle side of the outer frame) of the upper surface of the outer frame 31 (excluding the reserved portion) is greater than a width of the edge surface of the 3D glass cover plate, so that a filling space of the plastic frame body 20 is reserved.

According to an embodiment of the present disclosure, the injection mold includes a female mold and a male mold, and the female mold internally has an inner surface matching an outer surface structure of the 3D glass cover plate. The male mold includes a sidewall structure and a columnar insert matching an inner wall of the metal frame prefabricated body. The metal frame prefabricated body may be flexibly sleeved on the columnar insert, and an upper surface of the columnar insert matches an inner surface structure of the 3D glass cover plate. The male mold further includes an annular insert that can be sleeved on the columnar insert and can move up and down relative to the columnar insert. An annular groove matching the structure of the metal frame prefabricated body can be formed when the annular insert is sleeved on the columnar insert.

In the method of the present disclosure, the obtaining the 3D glass-metal composite prefabricated body by injection molding in step (3) includes: placing the 3D glass cover plate 10 obtained in step (1) in the female mold; sleeving the annular insert on the columnar insert to form a corresponding male mold, and placing the metal frame prefabricated body 30' in the male mold; pushing the annular insert to move along the columnar insert to a closed state of the female mold and the male mold, filling a gap between the 3D glass cover plate and the metal frame prefabricated body (including spaces between an inner wall of the 3D glass cover plate and the metal frame prefabricated body and between an outer wall of the columnar insert and the metal frame prefabricated body) with the injection molding material, and obtaining the 3D glass-metal composite prefabricated body through injection molding.

In the method of the present disclosure, a width of the reserved portion 33 is 1 to 5 mm in a direction perpendicular to an outer edge of the metal frame and extending outward.

In the method of the present disclosure, in the process of filling the injection molding material, the gap between the 3D glass cover plate 10 and the metal frame prefabricated body 30' is filled with the injection molding material, and preferably, an outer edge of the injection molding material is enabled to protrude out of an outer surface of the 3D glass cover plate 10 and to be positioned between outer edges of the metal frame prefabricated body 30'. By increasing the amount of the injection molding material, it is beneficial to increase the compactness of the prepared plastic frame body and optimize the sealing effect.

In the method of the present disclosure, in order to further increase the bonding force between the 3D glass cover plate 10 and the plastic frame body 20, convex ridges are also formed on an inner side of the curved part or on an inner side of a side edge of the glass cover plate 10. In the process of filling the injection molding material, the injection molding material is enabled to coat an outer periphery of the convex edges, so as to increase a bonding area between the glass cover plate 10 and the plastic frame body 20 and increase the bonding force.

In the method of the present disclosure, for example, in an embodiment of the present disclosure, the method further includes: in step (1), before the step of coating an activating agent on an edge surface of the 3D glass cover plate, at least coating ink on the edge surface of the glass cover plate and curing. The parts of the 3D glass cover plate on which the ink is coated may be determined according to the application condition of the 3D glass-metal composite body. For example, if the 3D glass-metal composite body is used as a front screen cover plate housing, the ink is only coated on the edge of the 3D glass cover plate, which mainly plays a role of shielding the ITO circuit. If the 3D glass-metal composite body is used as a rear screen housing, the ink is coated on an inner surface of the 3D glass cover plate (including the edge of the inner surface), which mainly plays a role of displaying the color of the 3D glass-metal composite body of a rear screen cover plate.

In the method of the present disclosure, in step (1), in order to improve the bonding force between the glass cover plate and the metal base material and reduce the risk of screen breakage, the 3D glass cover plate is a 3D glass cover plate of which the edge surface is roughened, so as to increase the surface roughness. The roughening treatment is well known to those skilled in the art, and details are not described herein again.

In the method of the present disclosure, the ink is not particularly limited in step (1), and may be various inks commonly used in the art. For example, the ink of an embodiment of the present disclosure is UV ink or thermosetting ink. A manner of coating the ink is not particularly limited, and may be any coating manner. In order to facilitate production, according to an embodiment of the present disclosure, the ink is coated by screen printing, and a thickness of the screen-printed ink is 5 to 15 µm. The specific screen printing method is well known to those skilled in the art, and details are not described herein again. Curing conditions after the ink is coated are not particularly limited, and may be selected according to the type of the ink, and the curing conditions are various conditions commonly used in the art. When the ink is the UV ink, the curing manner is exposure. Exposure conditions include: the power is 500 to 1200 kW, and the time is 1 to 5 min. When the ink is the thermosetting ink, the curing manner is drying, and drying conditions include: the temperature is 80 to 90°C, and the time is 50 to 100 min.

In the method of the present disclosure, in order to significantly improve the bonding force between the 3D glass cover plate and the metal base material and significantly reduce the risk of screen breakage, according to an embodiment of the present disclosure, in step (1), the activating agent includes an activating component, a diluent and a curing agent. Based on a weight of the activating agent, content of the activating component is 80 to 94 wt%, and is further 85 to 91 wt%, content of the diluent is 5 to 19 wt% and is further 6 to 10 wt%, and content of the curing agent is 1 to 10 wt%, and is further 3 to 5 wt%.

According to an embodiment of the present disclosure, the activating component is at least one of polyurethane, epoxy resin, polyimide, and polyacrylate.

According to an embodiment of the present disclosure, the diluent is at least one of acetone, ethyl acetate, and ethyl acetate.

According to an embodiment of the present disclosure, the curing agent is at least one of ethylenediamine, ethylene glycol, glycerol, and diethylenetriamine.

In the method of the present disclosure, in order to further improve the bonding force between the 3D glass cover plate and the metal frame and further reduce the risk of screen breakage, according to an embodiment of the present disclosure, a thickness of the coated activating agent is 5 to 15 µm. The coating manner may be screen printing. The screen printing method may include: using a 300 to 380 mesh screen printing plate and printing two layers back and forth. The specific operation method is well known to those skilled in the art, and details are not described herein again.

In the method of the present disclosure, in step (1), the drying conditions after the activating agent is coated are not particularly limited, and may be various conditions commonly used in the art. Preferably, the drying conditions include: the temperature is 75 to 90°C and the time is 40 to 120 min. In order to achieve the best effect, injection molding should be performed as soon as possible after drying. If the storage period is longer, the required injection molding temperature is higher.

In the method of the present disclosure, in step (2), a base material of the metal frame is not particularly limited, and may be various metal base materials commonly used in the art. According to an embodiment of the present disclosure, the metal base material is a stainless steel base material or an aluminum alloy base material.

The metal frame in the prior art is generally prepared by using a method including the following processing steps: sequentially performing machining and molding, polishing, chemical polishing, sandblasting treatment, anode oxidizing treatment, micropore treatment, and film laminating treatment on the stainless steel or aluminum alloy. In order to further improve the bonding force between the glass cover plate and the metal base material and further reduce the risk of screen breakage, according to an embodiment of the present disclosure, the metal frame is prepared by using a method including the following processing steps: sequentially performing machining and molding, polishing, chemical polishing, sandblasting treatment, anode oxidizing treatment, micropore treatment, and film laminating treatment (a film is laminated to the metal frame to prevent the anode oxide film from being scratched) on the stainless steel or aluminum alloy. The micropore pretreatment is added after the anode oxidizing treatment, so that an outer surface layer of the anode oxide film layer further forms micron-sized large corrosion holes. By such corrosion reconstruction holes, a plastic material will more easily and directly enter surface holes of the base material during the subsequent molding process, so as to form well bonding with the base material after the plastic frame body is formed, thereby further improving the bonding force between the glass cover plate and the metal base material.

According to an embodiment of the present disclosure, a micropore treatment manner includes: immersing the base material obtained by the anode oxidizing treatment in an etching solution, and forming corrosion holes with a pore diameter of 200 nm to 2000 nm in the outer surface layer of the anode oxide film layer. The etching solution may be a solution that corrodes the anode oxide film layer. For example, the concentration is generally adjusted with a solution that can dissolve alumina, and the solution may be an acid/alkali etching solution, for example, the solution may be selected from a solution having a pH of 10 to 13. According to an embodiment of the present disclosure, the etching solution is a single alkaline solution or a composite buffer solution having a pH of 10 to 13. The single alkaline solution having a pH of 10 to 13 may be an aqueous solution of Na₂CO₃, NaHCO₃, NaOH, K₂CO₃, KHCO₃, KOH or the like. According to an embodiment of the present disclosure, the etching solution is the aqueous solution of Na₂CO₃ and/or NaHCO₃. The corrosion holes can be uniformly distributed in the surface of the base material, and the pore diameter is uniform. The bonding performance between the glass cover plate and the base material is better. Solid content of the above etching solution may be 0.1 to 15 wt%. The composite buffer solution may be a mixed solution of a soluble hydrogen phosphate and a soluble base, for example, an aqueous solution of sodium dihydrogen phosphate and sodium hydroxide. Solid content of the aqueous solution of the sodium dihydrogen phosphate and sodium hydroxide may be 0.1 to 15 wt%. The composite buffer solution may alternatively be an aqueous solution of K₃PO₄ and K₂HPO₄ The composite buffer solution may alternatively be an aqueous ammonia solution, an aqueous solution of hydrazine, an aqueous solution of hydrazine derivative, an aqueous solution of a water-soluble amine compound, an aqueous solution of NH₃ to NH₄Cl, and the like. The immersing the base material obtained by the anode oxidizing treatment in an etching solution includes immersing the base material in the etching solution repeatedly. The time of each immersing may be 1 to 60 min. After each immersing, deionized water is used for washing. The number of times of the immersing may be 2 to 10 times. The washing may be cleaning in a water washing tank for 1 to 5 min, or placing in a water washing tank for 1 to 5 min.

The method of machining and molding, grinding, chemical polishing, sandblasting treatment, anode oxidizing treatment, and film laminating treatment is not particularly limited, and may be various methods commonly used in the art, which are well known to those skilled in the art. For example, conditions of sandblasting treatment may include: the sandblasting pressure is 0.23 to 0.25 MPa, the sandblasting treatment is repeated for 2 to 4 times, the walking speed is 12 to 22 Hz, where 205 ceramic sand may be used, and the swing frequency may be 33 Hz (a fixed frequency of the machine). Conditions of anode oxidizing treatment may include: the sulfuric acid concentration in the electrolyte is 10 to 30 wt%, the aluminum ion concentration is 10 to 30 g/L, the temperature is 15 to 25°C, the current density is 0.6 to 3 A/dm², and the voltage is 10 to 20 V, and the oxidation time is 30 min to 50 min.

In the method of the present disclosure, in order to further improve the bonding force between the 3D glass cover plate and the metal base material and further reduce the risk of screen breakage, according to an embodiment of the present disclosure, the method further includes: in step (2), coating an activating agent on an upper surface of the provided metal frame prefabricated body and drying. For the used activating agent, the coating manner of the activating agent, and the drying conditions, refer to the foregoing descriptions.

In the method of the present disclosure, according to an embodiment of the present disclosure, the injection molding manner in step (3) is room temperature injection molding. Further, injection molding conditions includes: an injection molding width (a thickness between the edge surface of the glass cover plate 10 and the upper surface of the outer frame 31 of the metal frame body 30) is 0.5 to 1 mm, the mold temperature is 15 to 35°C, and the injection molding temperature is 200 to 300°C.

In the method of the present disclosure, in order to significantly improve the bonding force between the glass cover plate and the metal base material, and significantly reduce the risk of screen breakage, according to an embodiment of the present disclosure, the injection molding material is at least one of polyamide, glass fiber, polycarbonate, and polyphenylene sulfide, is further a mixture of at least one of the polyamide, polycarbonate, and polyphenylene sulfide and the glass fiber, and more further is a mixture of the polyamide and the glass fiber.

According to an embodiment of the present disclosure, a ratio of a total weight of at least one of the polyamide, polycarbonate, and polyphenylene sulfide to a weight of the glass fiber is (0.5 to 5):1, and is further (1 to 3):1. Those skilled in the art should understand that when the injection molding material contains one of the polyamide, polycarbonate, and polyphenylene sulfide, the total weight of at least one of the polyamide, polycarbonate, and polyphenylene sulfide is a weight of the one substance. When the injection molding material contains two or more of the polyamide, polycarbonate, and polyphenylene sulfide, the total weight of at least one of the polyamide, polycarbonate, and polyphenylene sulfide is a sum of weights of the two or more substances.

In the method of the present disclosure, as described above, according to an embodiment of the present disclosure, an edge of the glass cover plate is roughened, and the metal frame is subjected to micropore treatment to form countless micropores in the surface. The activating agent is screen-printed on the processed glass cover plate and the metal frame, and the glass cover plate is placed in the metal frame by injection molding at room temperature to implement the bonding of metal base material, the plastic and the glass cover plate without steps.

In the method of the present disclosure, the 3D glass cover plate may be a 3D glass cover plate prepared by a conventional process. For example, the 3D glass cover plate may be prepared by using a conventional flat glass through processes such as blanking, hot bending, polishing, and strengthening. Flat glass base plates that may be used include, but are not limited to, Corning Gorilla Glass 4, Corning Gorilla Glass 3, Asahi Glass, SCHOTT Glass, etc. According to an embodiment of the present disclosure, a thickness of the glass base plate is 0.5 to 0.8 mm.

In the process of preparing the 3D glass cover plate, the blanking means that the flat glass is cut into the flat glass base plate of a desired size.

During the process of preparing the 3D glass cover plate, the hot bending is a process in which a glass is transformed from a flat surface to a curved surface, and includes three stages of preheating (at least three consecutive heating stages), compressing (at least two consecutive pressure-rising compressing stages and at least one pressure-holding compressing stage) and cooling (at least two consecutive cooling stages). For conditions of hot bending, refer to the conventional process in the art.

In the process of preparing the 3D glass cover plate, the polishing refers to a machining method which uses a mechanical action to reduce the surface roughness of a workpiece to obtain a bright and flat surface. The conventional technical means is to press a rotating polishing bristle wheel against the workpiece to enable the abrasive to produce rolling and micro-cutting on the surface of the workpiece. Generally, the surface roughness of the polished glass should reach Ra <0.2 µm.

In the process of preparing the 3D glass cover plate, the strengthening refers to the step of performing ion exchange between sodium ions and potassium ions on the surface of the glass to form a strengthened layer so as to improve the hardness of the glass. The strengthening process may be performed in a molten potassium nitrate. Process conditions include: immersing the glass in a high-purity potassium nitrate molten salt heated to 380°C to 450°C for 4 to 10h. Bending strength of the prepared 3D glass cover plate can reach 600 to 800 MPa.

According to an embodiment of the present disclosure, the 3D glass cover plate (especially the 3D glass-metal composite body used as the front screen cover plate housing) is OGS (One Glass Solution touch panel with a same name, and one piece of glass plays double roles of protective glass and a touch sensor at the same time) touch screen tempered glass, thereby reducing a thickness of the product, and breaking through a barrier that the injection molding affects the touch screen. Therefore, the glass cover plate and the metal frame are integrally molded, the product processes can be reduced, the cost is reduced, the product performances are improved, the product appearance is decorated and the product is enabled to be thinner and more practical.

A third aspect of the present disclosure provides a 3D glass-metal composite body prepared by using the above method of the present disclosure.

A fourth aspect of the present disclosure provides an electronic product, the electronic product includes a housing, and the housing is a 3D glass-metal composite body according to the present disclosure.

There is no particular limitation on the electronic product, as long as the electronic product has a 3D glass cover plate and a metal frame therein. The electronic product is a mobile phone, a tablet computer, a game machine, a watch, a laptop, a desktop computer, a television, or an instrument display. The 3D glass-metal composite body is a front screen cover plate housing or a rear screen cover plate housing of the electronic product.

Hereinafter, the present disclosure will be described in detail through embodiments. In the following embodiments, unless otherwise specified, the reagent materials used are commercially available, and the methods used are conventional methods in the art.

The polyurethane is purchased from DuPont under the brand number PA66 HTN501.

The epoxy resin is purchased from DuPont under the brand number PKHH.

The polyimide is purchased from DuPont under the brand number 200H.

The polyacrylate is purchased from Guangzhou Ketai Chemical Co., Ltd. under the brand number 7732-18-5.

The polyamide is purchased from DuPont under the brand number 73G20L.

The glass fiber is purchased from DuPont under the brand number FR530 NC010.

The polycarbonate is purchased from DuPont under the brand number CG943.

The polyphenylene sulfide is purchased from DuPont under the brand number HTN52G35HSL.

The conditions of sandblasting treatment comprise: 205 ceramic sand is used, the blasting pressure is 0.24 MPa, the sandblasting treatment is performed for 3 times, the walking speed is 18 Hz, and the swing frequency is 33 Hz.

The 3D glass structure used in the following embodiments and comparative example is as shown in FIG. 4, and the preparing method is as follows:
(1) The flat glass (Corning Gorilla Glass 4) is taken and cut into a flat glass base plate with a length, width, and thickness of 155*75*0.5 mm. The aforementioned flat glass base plate is placed into a molding mold, and the primary molding mold is placed in a molding furnace. Four-stage preheating, three-stage compressing, and two-stage cooling are respectively performed in order to form a curved glass blank. The process conditions of the four-stage preheating, three-stage compressing, and two-stage cooling are as shown in the table below, and the 3D glass blank is obtained

| | Preheating | | | | Compressing | | | Cooling | |
|---|---|---|---|---|---|---|---|---|---|
| | 1 | 2 | 3 | 4 | 1 | 2 | 3 | 1 | 2 |
| Temperature(°C) | 650 | 750 | 780 | 850 | 855 | 830 | 720 | 570 | 450 |
| Pressure(MPa) | 0.002 | | | | 0.06 | 0.5 | 0.65 | 0 | |

The pressures gradually increase from low to high in compressing 1 to 2, and the pressure is constant in compressing 3. The pressures are the maximum pressures in corresponding ranges in compressing 1 to 2 described in the table above.
(2) The 3D glass blank is polished: the surface roughness is enabled to meet the condition Ra <0.2 µm to obtain a 3D glass prefabricated body.
(3) The 3D glass prefabricated body is strengthened: after being heated to 380°C, the 3D glass prefabricated body is immersed in a potassium nitrate molten salt with a purity of 95% at a temperature of 420°C for 5h. After being taken out, the 3D glass prefabricated body is annealed in a heating furnace of 380°C to obtain the 3D glass cover plate with a bending resistance of 750 MPa. The length, width, and height of the 3D glass cover plate are 148 mm*73 mm*2.4 mm, and the thickness of the edge surface is 0.5 mm.

The structure of the aluminum alloy frame prefabricated body used in the following embodiments and comparative example is as shown in FIG. 5, and the specific structure is described as follows:

The aluminum alloy frame prefabricated body is adapted to the 3D glass cover plate structure prepared above, and includes an inner frame 32 and an outer frame 31 which are integrally formed, and a reserved portion 33. It is expected that an upper surface width of the outer frame 31 (the reserved portion is not calculated) is greater than the width of the aforementioned 3D glass cover plate by 0.8 mm. A width of the upper surface of the inner frame 32 is 2 mm. An upper surface of the inner frame 32 is higher than the upper surface of the outer frame 31 by 1.1 mm. For a width of the reserved portion 33, refer to the following embodiments.

The injection mold used in the following embodiments and comparative example is described as below:

The injection mold includes a female mold and a male mold, and the female mold internally has an inner surface matching an outer surface structure of the 3D glass cover plate. The male mold includes a sidewall structure and a columnar insert matching an inner wall of the metal frame prefabricated body. The metal frame prefabricated body may be flexibly sleeved on the columnar insert, and an upper surface of the columnar insert matches an inner surface structure of the 3D glass cover plate. The male mold further includes an annular insert that can be sleeved on the columnar insert and can move up and down relative to the columnar insert. The annular insert is sleeved on the columnar insert to form the corresponding male mold, and an annular groove matching the structure of the metal frame prefabricated body is formed in the male mold.

### Embodiment 1

(1) An edge surface of the 3D glass cover plate prepared above is roughened, and a 70 T screen printing plate is configured to screen-print UV ink on the edge surface of the 3D glass cover plate. A screen printing thickness of the UV ink is 10 µm, and then the UV ink is exposed for 3 min under an exposure machine of 900 kW. An activating agent is screen-printed on the UV ink with a 380-mesh screen printing plate, and a screen printing thickness of the activating agent is 10 µm. Then a glass is placed in a tunnel dryer of 90°C for drying for 90 min, where the activating agent is a polyurethane system and includes polyurethane, acetone, and ethylenediamine. Based on a weight of the activating agent, contents of the polyurethane, acetone, and ethylenediamine are 88 wt%, 8 wt%, and 4 wt%, respectively.
(2) An aluminum alloy is subjected to machining and molding, polishing, chemical polishing, sandblasting treatment, anode oxidizing treatment, micropore treatment, and film laminating treatment in sequence to obtain an aluminum alloy frame prefabricated body (for the structure, refer to the description above, where a width of the reserved portion is 1.5 mm), then a same activating agent as in step (1) is coated to an upper surface of the aluminum alloy frame prefabricated body, a coating thickness is 10 µm, and drying is performed at 80°C for 90 min. Anode oxidizing treatment conditions include: the concentration of sulfuric acid in the electrolyte is 20 wt%, the concentration of aluminum ions is 20 g/L, the temperature is 20°C, the current density is 1.5 A/dm², the voltage is 15 V, and the oxidation time is 40 min. Conditions of micropore treatment include: a base material is immersed in a 10 wt% sodium carbonate solution with a pH of 12, and the base material is taken out after 5 min, and is immersed in a beaker filled with water for 1 min. The operation is repeated for 5 times. The base material is dried after being immersed in water for the last time.
(3) The 3D glass cover plate obtained in step (1) is placed in the female mold, the aluminum alloy frame prefabricated body obtained in step (2) is placed in an annular groove of the male mold, and the female mold and the male mold are assembled. A gap between the 3D glass cover plate and the aluminum alloy frame prefabricated body is filled with an injection molding material (the injection molding material is obtained by mixing polyamide and glass fiber in a weight ratio of 2:1, and preheating to 250°C in an oven), so that the gap between the 3D glass cover plate and the aluminum alloy frame prefabricated body (including an annular hollow cavity formed among an inner wall of the 3D glass cover plate, an outer wall of the columnar insert, and the upper surface of the aluminum alloy frame prefabricated body, the same below) is filled with the injection molding material. Besides, an outer edge of the injection molding material is enabled to protrude out of an outer surface of the 3D glass cover plate and is located inside an outer edge of the aluminum alloy frame prefabricated body. An 3D glass-metal composite prefabricated body is obtained by injection molding (an injection molding width is 0.8 mm, the mold temperature is 30°C, and the temperature of the injection molding material is 250°C).
(4) A CNC process is adopted to remove the reserved portion of the aluminum alloy frame in the 3D glass-metal composite prefabricated body and a protruding part of the plastic frame body, so that outer peripheries of the 3D glass cover plate, the plastic frame body, and the metal frame are in smooth transition along curvature of the 3D glass cover plate without steps, thereby obtaining a 3D glass-metal composite body product A1.

### Embodiment 2

(1) An edge surface of the 3D glass cover plate prepared above is roughened, thermosetting ink is screen-printed on the edge surface of the 3D glass cover plate with a 70 T screen printing plate, and a screen printing thickness of the thermosetting ink is 15 µm. Then the thermosetting ink is dried in an oven of 80°C for 90 min, an activating agent is screen-printed on the thermosetting ink with a 300-mesh screen printing plate, and a screen printing thickness of the activating agent is 15 µm. Then a glass is placed in a tunnel dryer of 80°C to be dried for 110 min, where the activating agent is a polyurethane system and includes polyurethane, ethyl acetate, and ethylene glycol. Based on a weight of the activating agent, contents of the polyurethane, ethyl acetate, and ethylene glycol are 85 wt%, 10 wt%, and 5 wt%, respectively.
(2) An aluminum alloy is subjected to machining and molding, polishing, chemical polishing, sandblasting treatment, anode oxidizing treatment, micropore treatment, and film laminating treatment in sequence to obtain an aluminum alloy frame prefabricated body (the structure refers to the description above, where a width of the reserved portion is 1.5 mm). A same activating agent as in step (1) is coated on an upper surface of the aluminum alloy frame prefabricated body, a coating thickness is 15 µm, and the activating agent is dried at 75°C for 110 min. Conditions of the anode oxidizing treatment include: the concentration of sulfuric acid in the electrolyte is 15 wt%, the concentration of aluminum ions is 28 g/L, the temperature is 15°C, the current density is 1 A/dm², the voltage is 10 V, and the oxidation time is 50 min. Conditions of micropore treatment include: a base material is immersed in a 15 wt% sodium bicarbonate solution with a pH of 10, and the base material is taken out after 5 min, and immersed in a beaker filled with water for 1 min. The operation is repeated for 5 times. The base material is dried after being immersed in water for the last time.
(3) The 3D glass cover plate obtained in step (1) is placed in the female mold, the aluminum alloy frame prefabricated body obtained in step (2) is placed in an annular groove of the male mold, and the female mold and the male mold are assembled. A gap between the 3D glass cover plate and the aluminum alloy frame prefabricated body is filled with an injection molding material (the injection molding material is obtained by mixing polyamide and glass fiber in a weight ratio of 1:1, and preheating to 300°C in an oven), so that the gap between the 3D glass cover plate and the aluminum alloy frame prefabricated body is filled with the injection molding material. Besides, an outer edge of the injection molding material is enabled to protrude out of an outer surface of the 3D glass cover plate and is located inside an outer edge of the aluminum alloy frame prefabricated body. An 3D glass-metal composite prefabricated body is obtained by injection molding (an injection molding width is 1 mm, the mold temperature is 15°C, and the temperature of the injection molding material is 300°C).
(4) A CNC process is adopted to remove the reserved portion of the aluminum alloy frame in the 3D glass-metal composite prefabricated body and a protruding part of the plastic frame body, so that outer peripheries of the 3D glass cover plate, the plastic frame body, and the metal frame are in smooth transition along curvature of the 3D glass cover plate without steps, thereby obtaining a 3D glass-metal composite body product A2.

### Embodiment 3

(1) An edge surface of the 3D glass cover plate prepared above is roughened, a thermosetting ink is screen-printed on the edge surface of the 3D glass cover plate with a 70 T screen printing plate, and a screen printing thickness of the thermosetting ink is 5 µm. Then the thermosetting ink is dried in the oven of 90°C for 60 min, an activating agent is screen-printed on the thermosetting ink with a 300-mesh screen printing plate, and a screen printing thickness of the activating agent is 8 µm. Then a glass is placed in a tunnel dryer of 80°C to be dried for 50 min, where the activating agent is a polyurethane system and includes polyurethane, ethyl acetate, and diethylenetriamine. Based on a weight of the activating agent, contents of the polyurethane, ethyl acetate, and diethylenetriamine are 91 wt%, 6 wt%, and 3 wt%, respectively.
(2) An aluminum alloy is subjected to machining and molding, polishing, chemical polishing, sandblasting treatment, anode oxidizing treatment, micropore treatment, and film laminating treatment in sequence to obtain an aluminum alloy frame prefabricated body (for the structure, refer to the description above, where a width of the reserved portion is 1.5 mm). A same activating agent as in step (1) is coated on an upper surface of the aluminum alloy frame prefabricated body, a coating thickness is 5 µm, and the activating agent is dried at 90°C for 60 min. Conditions of the anode oxidizing treatment include: the concentration of sulfuric acid in the electrolyte is 25 wt%, the concentration of aluminum ions is 15 g/L, the temperature is 25 °C, the current density is 2.5 A/dm², the voltage is 20 V, and the oxidation time is 30 min. Conditions of micropore treatment include: a base material is immersed in a 15 wt% sodium bicarbonate solution with a pH of 10, and the base material is taken out after 5 min, and immersed in a beaker filled with water for 1 min. The operation is repeated for 5 times. The base material is dried after being immersed in water for the last time.
(3) The 3D glass cover plate obtained in step (1) is placed in the female mold, the aluminum alloy frame prefabricated body obtained in step (2) is placed in an annular groove of the male mold, and the female mold and the male mold are assembled. A gap between the 3D glass cover plate and the aluminum alloy frame prefabricated body is filled with an injection molding material (the injection molding material is obtained by mixing polyamide and glass fiber in a weight ratio of 3:1, and preheating to 200°C in an oven), so that the gap between the 3D glass cover plate and the aluminum alloy frame prefabricated body is filled with the injection molding material. Besides, an outer edge of the injection molding material is enabled to protrude out of an outer surface of the 3D glass cover plate and is located inside an outer edge of the aluminum alloy frame prefabricated body. An 3D glass-metal composite prefabricated body is obtained by injection molding (an injection molding width is 0.5 mm, the mold temperature is 35°C, and the temperature of the injection molding material is 200°C).
(4) A CNC process is adopted to remove the reserved portion of the aluminum alloy frame in the 3D glass-metal composite prefabricated body and A protruding part of the plastic frame body, so that outer peripheries of the 3D glass cover plate, the plastic frame body, and the metal frame are in smooth transition along curvature of the 3D glass cover plate without steps, thereby obtaining a 3D glass-metal composite body product A3.

### Embodiment 4

A 3D glass-metal composite body product A4 is prepared according to the method of Embodiment 1. The difference is that the activating agent is a polyurethane system, and includes polyurethane, acetone, and ethylenediamine. Based on the weight of the activating agent, the contents of the polyurethane, acetone, and ethylenediamine are 80 wt%, 10 wt%, and 10 wt%, respectively.

### Embodiment 5

A 3D glass-metal composite body product A5 is prepared according to the method of Embodiment 1, and the difference is that epoxy resin is used instead of polyurethane in the activating agent.

### Embodiment 6

A 3D glass-metal composite body product A6 is prepared according to the method of Embodiment 1, and the difference is that polyimide is used instead of polyurethane in the activating agent.

### Embodiment 7

A 3D glass-metal composite body product A7 is prepared according to the method of Embodiment 1, and the difference is that polyacrylate is used instead of polyurethane in the activating agent.

### Embodiment 8

A 3D glass-metal composite body product A8 is prepared according to the method of Embodiment 1, and the difference is that in step (2), before the injection molding, the activating agent is not coated on the upper surface of the aluminum alloy frame.

### Embodiment 9

A 3D glass-metal composite body product A9 is prepared according to the method of Embodiment 1. The difference is that no microporous treatment is performed during the process of preparing the aluminum alloy frame prefabricated body.

### Embodiment 10

A 3D glass-metal composite body product A10 is prepared according to the method of Embodiment 1. The difference is that the injection molding material is formed by mixing polycarbonate and glass fiber according to a weight ratio of 2:1.

### Embodiment 11

A 3D glass-metal composite body product A11 is prepared according to the method of Embodiment 1. The difference is that the injection molding material is formed by mixing polyphenylene sulfide and glass fiber at a weight ratio of 2:1.

### Embodiment 12

A 3D glass-metal composite body product A12 is prepared according to the method of Embodiment 1, and the difference is that the injection molding material is formed by mixing polyamide and glass fiber at a weight ratio of 0.5:1.

### Embodiment 13

A 3D glass-metal composite body product A13 is prepared according to the method of Embodiment 1, and the difference is that the injection molding material is polyphenylene sulfide.

### Embodiment 14

A 3D glass-metal composite body product A14 is prepared according to the method of Embodiment 1, and the difference is that the injection molding material is polyamide.

### Embodiment 15

A 3D glass-metal composite body product A15 is prepared according to the method of Embodiment 1, and the difference is that the injection molding material is polycarbonate.

### Embodiment 16

A 3D glass-metal composite body product A16 is prepared according to the method of Embodiment 1, and the difference is that the injection molding material is glass fiber.

### Embodiment 17

A 3D glass-metal composite body product A17 is prepared according to the method of Embodiment 1. The difference is that during the filling of the injection molding material, the gap between the 3D glass cover plate and the aluminum alloy frame prefabricated body is filled with the injection molding material, and the outer edge of the injection molding material does not protrude out of the outer surface of the 3D glass cover plate, and is flush with the outer surface of the 3D glass cover plate.

### Embodiment 18

A 3D glass-metal composite body product A18 is prepared according to the method of Embodiment 1, and the difference is that the upper surface of the inner frame and the upper surface of the outer frame in the adopted aluminum alloy frame prefabricated body are flush.

### Comparative Example 1

According to the method of Embodiment 1, the difference is that the method comprises steps (1) to (3), wherein:
Step (1): the above 3D glass cover plate is roughened, UV ink is screen-printed on the edge of the glass with a 70 T screen printing plate, a screen printing thickness of the UV ink is 10 µm, and then the UV ink is exposed under a 900 kW exposure machine for 3 min.
Step (2): an aluminum alloy is subjected to machining and molding, polishing, chemical polishing, sandblasting treatment, anode oxidizing treatment, micropore treatment, and film laminating treatment in sequence to obtain an aluminum alloy frame prefabricated body.
Step (3): a plastic gasket is placed between the glass cover plate obtained in step (1) and the aluminum alloy base material plate frame obtained in step (2), glue is coated on the glass cover plate and the aluminum alloy base material plate frame, and the glass cover plate is placed in the aluminum alloy base material plate frame, and is then placed in a 90°C drying oven to be dried for 30 min, thereby obtaining a 3D glass-metal composite D1.

### Test example

The following various performance tests are performed on the 3D glass-metal composite bodies A1 to A18 and D1.
1. Flatness test: the surface flatness of the glass cover plate of each 3D glass-metal composite body is measured with a three-coordinate measuring machine (purchased from Hexagon, and the model is global classic 050705). The results are shown in Table 1.
2. Mirror thrust test: a universal material mechanical testing machine (purchased from INSTRON, the model is 3369, and the advance speed is 10 mm/min) is used to test the bonding force between the glass cover plate and the metal frame of each 3D glass-metal composite body. The metal frame is fixed, and the glass cover plate is pushed until the glass breaks or the glass falls off. 30 parallel tests are repeated, and the average value is solved. The results are shown in Table 1.
3. Each 3D glass-metal composite body is assembled into a complete machine and a drop test is performed: no load drop test is performed, and the height is 1 m. After the drop test, the maximum number of times that the product does not show deformation, indentation, and damage is recorded. The results are shown in Table 1.
4. Temperature shock test: each 3D glass-metal composite body is put into a temperature shock tester (purchased from KSON Co., Ltd., and the model is KSKC-415TBS), and is placed at -40°C for 2h and at 85°C for 2h. The above is a cycle, and 5 cycles are performed in total. Then each 3D glass-metal composite body is placed at 25°C for 4h. The product is qualified if the defects such as corrosion, spots, color losing, color change, cracks, blistering and distortion, and the phenomenon of fingernail scratches do not exist before/after the test. The results are shown in Table 1.
5. Moist heat cycle test: each 3D glass-metal composite body is placed in a constant temperature and constant humidity box of 50°C and 95% humidity for 72h. The product is qualified if the defects such as corrosion, spots, color losing, color change, cracks, blistering and distortion, and the phenomenon of fingernail scratches do not exist before/after the test. The results are shown in Table 1.
6. Salt spray test: each 3D glass-metal composite body is placed in a salt spray chamber, and the surface of the product is continuously sprayed with a 5 wt% NaCl solution with a Ph value of 6.8 at a temperature of 35°C and a humidity of 90% for 2h. Then each product is placed in a constant temperature and constant humidity box of 50°C and 95% humidity for 22h. The above is a cycle and 3 cycles are performed in total for 72h. Then each product is rinsed gently with warm water of 38°C and wiped clean with dust-free cloth. After standing at room temperature for 2h, the sample is checked. The product is qualified if the appearance of the film is not abnormal and the appearance does not change significantly (such as rust, color change and blistering). The results are shown in Table 1.
7. Chemical resistance test: edible oil, sunscreen, lipstick, liquid foundation, mosquito repellent, hand cream and the like are smeared on each 3D glass-metal composite body evenly. The product is put in a constant temperature and constant humidity box at a temperature of 70°C and a humidity of 90% for 24h, and then placed at 25°C for 4h. The product is qualified if there is no obvious residual trace after the product is wiped with alcohol. The results are shown in Table 1.
8. Waterproof performance test: IPX7 short-term water immersion test is performed, the assembled whole machine is immersed in water for 30 min, the top of the workpiece should be at least 150 mm deep, and the lowest part at least withstands 1 m of water pressure. The product is qualified if the workpiece can work normally after being taken out of the water surface, subjected to surface drying and placed for 30 min. The results are shown in Table 2.

**Table 1**

| | Flatness | Mirror thrust | Drop test | Temperature shock test | Moist heat cycle test | Salt spray test | Chemical resistance test | Waterproof performance test |
|---|---|---|---|---|---|---|---|---|
| A1 | ≤0.2 mm | 3200 N | 100 times | qualified | qualified | qualified | qualified | qualified |
| A2 | ≤0.2 mm | 3110 N | 100 times | qualified | qualified | qualified | qualified | qualified |
| A3 | ≤0.2 mm | 3150 N | 100 times | qualified | qualified | qualified | qualified | qualified |
| A4 | ≤0.2 mm | 3020 N | 90 times | qualified | qualified | qualified | qualified | qualified |
| A5 | ≤0.2 mm | 2400 N | 80 times | qualified | qualified | qualified | qualified | qualified |
| A6 | ≤0.2 mm | 2400 N | 80 times | qualified | qualified | qualified | qualified | qualified |
| A7 | ≤0.2 mm | 2340 N | 80 times | qualified | qualified | qualified | qualified | qualified |
| A8 | ≤0.2 mm | 2000 N | 60 times | qualified | qualified | qualified | qualified | qualified |
| A9 | ≤0.2 mm | 2220 N | 70 times | qualified | qualified | qualified | qualified | qualified |
| A10 | ≤0.2 mm | 2105 N | 60 times | qualified | qualified | qualified | qualified | qualified |
| A11 | ≤0.2 mm | 2080 N | 60 times | qualified | qualified | qualified | qualified | qualified |
| A12 | ≤0.2 mm | 2300 N | 80 times | qualified | qualified | qualified | qualified | qualified |
| A13 | ≤0.2 mm | 1350 N | 40 times | qualified | qualified | qualified | qualified | qualified |
| A14 | ≤0.2 mm | 1550 N | 40 times | qualified | qualified | qualified | qualified | qualified |
| A15 | ≤0.2 mm | 1420 N | 40 times | qualified | qualified | qualified | qualified | qualified |
| A16 | ≤0.2 mm | 1100 N | 30 times | qualified | qualified | qualified | qualified | qualified |
| A17 | ≤0.2 mm | 3000 N | 90 times | qualified | qualified | qualified | qualified | qualified |
| A18 | ≤0.3 mm | 3050 N | 90 times | qualified | qualified | qualified | qualified | qualified |
| D1 | ≤0.2 mm | 350 N | 10 times | qualified | qualified | qualified | qualified | not qualified |

As can be seen from Table 1, the method of the present disclosure can greatly improve the bonding force between the glass cover plate and the metal base material plate frame of the prepared 3D glass-metal composite body, thereby greatly reducing the risk of glass falling and the risk of screen breakage after falling, and significantly improving product performances.

In addition, it can be seen from the appearance inspection method that the bonding parts of the 3D glass-metal composite bodies prepared according to Embodiments 1 to 18 of the present disclosure have relatively complete size matching, and the problem of assembling steps and gaps between the glass and metal is avoided. The bonding part of the 3D glass-metal composite body prepared in Document 1 has the problem of obvious assembling gaps and steps between the glass and metal.

The preferred embodiments of the present disclosure are described in detail above, but the present disclosure is not limited to this. Various simple variations may be made to the technical solutions of the present disclosure within the scope of the technical idea of the present disclosure, various technical features may be combined in any appropriate way, and such simple variations and combinations shall be regarded as the content of the present disclosure and fall within the protection scope of the present disclosure.

## Claims

1. A 3D glass-metal composite body, wherein the 3D glass-metal composite body comprises a 3D glass cover plate (10), a plastic frame body (20), and a metal frame (30), an upper surface of the metal frame (30) and an edge surface of the 3D glass cover plate (10) are oppositely disposed, at least a part of the plastic frame body (20) is formed between the edge surface of the 3D glass cover plate (10) and the upper surface of the metal frame (30), and outer peripheries of the 3D glass cover plate (10), the plastic frame body (20) and the metal frame (30) are in smooth transition along curvature of the 3D glass cover plate (10) without steps.

2. The 3D glass-metal composite body according to claim 1, wherein the metal frame (30) comprises an outer frame (31) and an inner frame (32) which are integrally formed, the outer frame (31) and the edge surface of the 3D glass cover plate (10) are oppositely disposed, and the inner frame (32) is formed on an inner side of the outer frame (31); and the outer periphery of the plastic frame body (20) and an outer periphery of the outer frame (31), and an inner periphery of the plastic frame body (20) and an inner periphery of the inner frame (32) are correspondingly formed between the 3D glass cover plate (10) and the metal frame (30).

3. The 3D glass-metal composite body according to claim 2, wherein an upper surface of the inner frame (32) is higher than an upper surface of the outer frame (31); and the upper surface of the inner frame (32) and the upper surface of the outer frame (31) are connected in an arc-shaped transition manner.

4. The 3D glass-metal composite body according to any one of claims 1 to 3, wherein the 3D glass cover plate (10) is a double-curved glass cover plate.

5. The 3D glass-metal composite body according to any one of claims 1 to 4, wherein the material of the plastic frame body (20) is at least one of polyamide, glass fiber, polycarbonate, and polyphenylene sulfide, preferably a mixture of at least one of the polyamide, polycarbonate, and polyphenylene sulfide and the glass fiber, more preferably a mixture of the polyamide and the glass fiber, and even more preferably, in the plastic frame body, a ratio of a total weight of at least one of the polyamide, polycarbonate, and polyphenylene sulfide to a weight of the glass fiber is 0.5 to 5:1, and still more preferably 1 to 3:1.

6. The 3D glass-metal composite body according to any one of claims 1 to 5, wherein a base material of the metal frame (30) is a stainless steel base material or an aluminum alloy base material.

7. The 3D glass-metal composite body according to any one of claims 1 to 6, wherein an anode oxide film layer is formed on a surface of the metal frame, and micropores are formed in an outer surface layer of the anode oxide film layer, and a part of the plastic frame body is filled into the micropores.

8. The 3D glass-metal composite body according to claim 2 or 3, wherein the width of the upper surface of the outer frame (31) is greater than a width of the edge surface of the 3D glass cover plate (10).

9. The 3D glass-metal composite body according to claim 2 or 3, wherein the outer periphery of the plastic frame body 20 corresponds to the outer periphery of the outer frame 31, and the inner periphery of the plastic frame body 20 corresponds to the inner periphery of the inner frame 32.

10. A preparing method for a 3D glass-metal composite body, wherein the method comprises the following steps:
(1) providing a 3D glass cover plate (10), coating an activating agent on an edge surface of the 3D glass cover plate, and drying;
(2) providing a metal frame prefabricated body (30'), wherein a reserved portion (33) extending outward along an outer periphery of the metal frame (30) is reserved for the metal frame prefabricated body relative to a final structure of the metal frame (30);
(3) placing the 3D glass cover plate (10) obtained in step (1) and the metal frame prefabricated body (30') in an injection mold, wherein an upper surface of the metal frame prefabricated body (30') and the edge surface of the 3D glass cover plate (10) are oppositely disposed, an injection molding material is filled between the edge surface of the 3D glass cover plate (10) and the upper surface of the metal frame prefabricated body (30'), at least a part of the injection molding material is formed between the edge surface of the 3D glass cover plate (10) and the upper surface of the metal frame prefabricated body (30'), and a 3D glass-metal composite prefabricated body is obtained by injection molding; and
(4) performing cutting treatment on the 3D glass-metal composite prefabricated body, and removing the reserved portion (33) in the metal frame prefabricated body (30') to obtain the 3D glass-metal composite body.

11. The method according to claim 10, wherein the metal frame comprises an outer frame (31) and an inner frame (32) which are integrally formed, the outer frame (31) and the edge surface of the 3D glass cover plate (10) are oppositely disposed, the inner frame (32) is formed on an inner side of the outer frame (31), and the reserved portion (33) is formed on an outer periphery of the outer frame (31); an upper surface of the inner frame (32) is higher than an upper surface of the outer frame (31); and the upper surface of the inner frame (32) and the upper surface of the outer frame (31) are connected in an arc-shaped transition manner.

12. The method according to claim 10 or 11, wherein a width of the reserved portion (33) is 1 to 5 mm in a direction perpendicular to an outer edge of the metal frame (30) and extending outward.

13. The method according to any one of claims 10 to 12, wherein in the process of filling the injection molding material, a gap between the 3D glass cover plate (10) and the metal frame prefabricated body (30') is filled with the injection molding material, and an outer edge of the injection molding material is enabled to protrude out of an outer surface of the 3D glass cover plate (10) and to be positioned between outer edges of the metal frame prefabricated body (30').

14. The method according to any one of claims 10 to 13, further comprising: coating an activating agent on the upper surface of the provided metal frame prefabricated body (30'), and drying.

15. The method according to any one of claims 10 to 14, further comprising: before the step of coating an activating agent on the edge surface of the 3D glass cover plate (10), at least coating ink on the edge surface of the glass cover plate (10) and curing; wherein
the ink is UV ink or thermosetting ink; and
the ink is coated by screen printing, and a thickness of the screen-printed ink is 5 to 15 µm.

16. The method according to any one of claims 10 to 14, wherein the activating agent comprises an activating component, a diluent, and a curing agent, and based on a weight of the activating agent, content of the activating agent is 80 to 94 wt%, preferably 85 to 91 wt%; content of the diluent is 5 to 19 wt%, preferably 6 to 10 wt%; and content of the curing agent is 1 to 10 wt%, preferably 3 to 5 wt%;
the activating component is at least one of polyurethane, epoxy resin, polyimide, and polyacrylate;
the diluent is at least one of acetone, ethyl acetate and ethyl acetate;
the curing agent is at least one of ethylenediamine, ethylene glycol, glycerol, and diethylenetriamine; and
a thickness of the coated activating agent is 5 to 15 µm.

17. The method according to any one of claims 10 to 14, wherein a base material of the metal frame (30) is a stainless steel base material or an aluminum alloy base material, and
the metal frame (30) is prepared by using a method comprising the following processing steps: sequentially performing machining and molding, polishing, chemical polishing, sandblasting treatment, anode oxidizing treatment, micropore treatment, and film laminating treatment on a stainless steel or aluminum alloy.

18. The method according to any one of claims 10 to 14, wherein the injection molding conditions comprise: an injection molding width is 0.5 to 1 mm, a mold temperature is 15 to 35°C, and an injection molding material temperature is 200 to 300°C; and
preferably, the injection molding material is at least one of polyamide, glass fiber, polycarbonate, and polyphenylene sulfide, more preferably, a mixture of at least one of the polyamide, polycarbonate, and polyphenylene sulfide and the glass fiber, and further preferably a mixture of the polyamide and the glass fiber, and even more preferably, a ratio of a total weight of at least one of the polyamide, polycarbonate, and polyphenylene sulfide to a weight of the glass fiber is 0.5 to 5:1, and still more preferably 1 to 3:1.

19. A 3D glass-metal composite body prepared by using the method according to any one of claims 10 to 18.

20. An electronic product, comprising a housing, wherein the housing is the 3D glass-metal composite body according to any one of claims 1 to 9 and 19;
the electronic product is a mobile phone, a tablet computer, a game machine, a watch, a laptop, a desktop computer, a television or an instrument display; and
the housing is a front screen housing or a rear screen housing of the electronic product, or a waterproof watch case.
